# DEMANDE DE BREVET EUROPEEN

(11) **EP 3 624 202 A1**
(43) Date de publication de la demande: **18.03.2020**
(21) Numéro de dépôt: 19195419.7
(22) Date de dépôt: 04.09.2019
(51) Int. Cl.: H01L 29/778, H01L 21/336, H01L 29/423, H01L 29/45, H01L 29/417, H01L 29/49, H01L 29/20

(54) **TRANSISTOR BIDIRECTIONNEL À HÉTÉROJONCTION À FAIBLE RÉSISTANCE À L'ÉTAT PASSANT**

(30) Priorité: 11.09.2018 FR 1871019
(71) Demandeur: Commissariat à l'Énergie Atomique et aux Énergies Alternatives, 75015 Paris (FR)
(72) Inventeur: ESCOFFIER, René, 38054 GRENOBLE Cedex 9 (FR)
(74) Mandataire: Guérin, Jean-Philippe

(57) **Abrégé**

L'invention porte sur un transistor bidirectionnel à hétérojonction avec :
-des première et deuxième électrodes de conduction (11, 12), des première et deuxième grilles (21, 22) entre les électrodes de conduction, et des première et deuxième électrodes de référence (31, 32) entre les grilles ;
-une superposition de couches semiconductrices (7, 9), comprenant :
-des zones de canal (81, 82) à la verticale des grilles ;
-une première zone de conduction (83) entre la première électrode de conduction et la première zone de canal ;
-une deuxième zone de conduction (84) entre la deuxième électrode de conduction et la deuxième zone de canal ;
-une troisième zone de conduction (85) séparée des première et deuxième zones de conduction par les première et deuxième zones de canal respectivement ;
-une première liaison électrique (311) connectée à la troisième zone de conduction (85) et à la première électrode de référence.

## Description

L'invention concerne les montages de transistors de puissance bidirectionnels utilisés par exemple pour des applications hautes fréquences, et en particulier ceux nécessitant un fonctionnement bidirectionnel basé sur des transistors à haute mobilité électronique.

De nombreuses applications électroniques nécessitent dorénavant un fonctionnement à des fréquences de plus en plus élevées. Ces applications ne sont pas limitées au marché des télécommunications. Des commutateurs dans des gammes de fréquences élevées sont également nécessaires dans l'électronique embarquée à destination de l'automobile et des transports terrestres, dans l'aéronautique, dans les systèmes médicaux ou dans des solutions domotiques par exemple. Ces applications nécessitent pour la plupart des commutateurs sous forte puissance fonctionnant dans des gammes de fréquences supérieures au megahertz.

Historiquement, des commutateurs hautes fréquences de puissance ont longtemps fait appel à des transistors à effet de champ basés sur un canal semi-conducteur. Pour des fréquences plus faibles, les transistors à jonction sont préférés car ils supportent des densités de courant plus élevées. Cependant, du fait de la tension de claquage relativement limitée de chacun de ces transistors, les applications de puissance nécessitent l'utilisation d'un grand nombre de transistors en série. Les pertes à travers ces transistors en série sont importantes, aussi bien en régime établi qu'en commutation, ce qui constitue un inconvénient majeur de ce type de solution.

Une alternative pour des commutateurs de puissance en hautes fréquences est l'utilisation de transistors à effet de champ à haute mobilité d'électrons, également désignés par le terme de transistor à effet de champ à hétérostructure. Un tel transistor inclut la superposition de deux couches semiconductrices ayant des bandes interdites différentes formant un puit quantique à leur interface. Des électrons sont confinés dans ce puits quantique pour former un gaz bidimensionnel d'électrons. Pour des raisons de tenue en haute tension et en température, ces transistors sont choisis de façon à présenter une large bande d'énergie interdite.

Parmi les transistors HEMT à large bande d'énergie interdite, les transistors à base de nitrure de gallium sont très prometteurs. Leur largeur de bande d'énergie interdite induit une tension d'avalanche plus haute comparée aux matériaux classiques de l'électronique, une vitesse élevée de saturation des porteurs et de bonnes stabilités thermique et chimique. Le champ de claquage du nitrure de gallium peut ainsi être supérieur à 3x10⁶ V/cm, ce qui permet aisément de réaliser des transistors avec des tensions de claquage supérieures à 100 V. De plus, de tels transistors permettent de très grandes densités de courant du fait de la très grande mobilité électronique dans le gaz d'interface.

Le nitrure de gallium présente une bande d'énergie interdite large de 3,39eV. De plus, des alliages ternaires tels que du AlGaN ou InGaN peuvent aisément être réalisés à partir du GaN. Un transistor HEMT à base de nitrure de gallium peut aussi être réalisé sur un substrat en silicium. Le transistor GaN HEMT a donc un coût de production beaucoup plus faible qu'un transistor à base de SiC par exemple. Même si un transistor à base de SiC présente également une large bande d'énergie interdite, des alliages ternaires peuvent difficilement être réalisés à partir de ce matériau, et il ne peut pas être réalisé sur substrat silicium standard, ce qui rend le coût de fabrication prohibitif et en limite fortement les applications.

Le brevet EP2736078 décrit un transistor bidirectionnel à haute mobilité d'électrons, basé sur l'utilisation d'un empilement d'une couche de GaN et d'une couche d'AlGaN. Le transistor comporte des électrodes de conduction, entre lesquelles une grille de commande est positionnée. Un canal d'électrons s'étend entre les électrodes de conduction. La grille est polarisée par rapport à un contact de référence situé au milieu du canal d'électrons. Pour supporter des tensions importantes, et donc augmenter la tension de claquage du transistor, il est nécessaire de respecter une distance minimale de 10µm entre la grille et chacune des électrodes de conduction pour un fonctionnement bidirectionnel. Un tel transistor bidirectionnel présente donc l'inconvénient d'augmenter l'encombrement du composant et sa résistance à l'état passant par rapport à un transistor unidirectionnel.

L'invention vise à résoudre un ou plusieurs de ces inconvénients. L'invention porte ainsi sur un dispositif incluant un transistor bidirectionnel à hétérojonction à effet de champ, tel que défini dans la revendication 1 annexée.

L'invention porte également sur les variantes des revendications dépendantes. L'homme du métier comprendra que chacune des caractéristiques des variantes présentées dans la description ou dans les revendications dépendantes peut être combinée indépendamment aux caractéristiques d'une revendication indépendante, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :
[Fig.1] est une vue en coupe transversale d'un transistor de type HEMT selon un mode de réalisation de l'invention ;
[Fig.2] est une vue de dessus du transistor de la figure 1 ;
[Fig.3] est une vue en coupe transversale du transistor de la figure 1 à l'état passant ;
[Fig.4] illustre un diagramme tension / courant entre les électrodes de conduction du transistor à l'état passant ;
[Fig.5] est une vue en coupe transversale d'un transistor de type HEMT selon un mode de réalisation de l'invention, à l'état bloqué ;
[Fig.6] est une vue de dessus du transistor de la figure 5 ;
[Fig.7] illustre un diagramme tension / courant entre les électrodes de conduction du transistor à l'état bloqué ;
[Fig.8] est une vue en coupe transversale d'un transistor de type HEMT selon un mode de réalisation de l'invention, à l'état passant dissymétrique ;
[Fig.9] est une vue de dessus du transistor de la figure 8 ;
[Fig.10] illustre un diagramme tension / courant entre les électrodes de conduction du transistor dans un état passant dissymétrique ;
[Fig.11] illustre un diagramme tension / courant entre les électrodes de conduction du transistor dans un état bloqué dissymétrique ;
[Fig.12] illustre une étape d'un procédé de fabrication d'un transistor selon un mode de réalisation de l'invention ;
[Fig.13] une autre étape d'un procédé de fabrication d'un transistor selon un mode de réalisation de l'invention ;
[Fig.14] une autre étape d'un procédé de fabrication d'un transistor selon un mode de réalisation de l'invention ;
[Fig.15] une autre étape d'un procédé de fabrication d'un transistor selon un mode de réalisation de l'invention ;
[Fig.16] une autre étape d'un procédé de fabrication d'un transistor selon un mode de réalisation de l'invention.

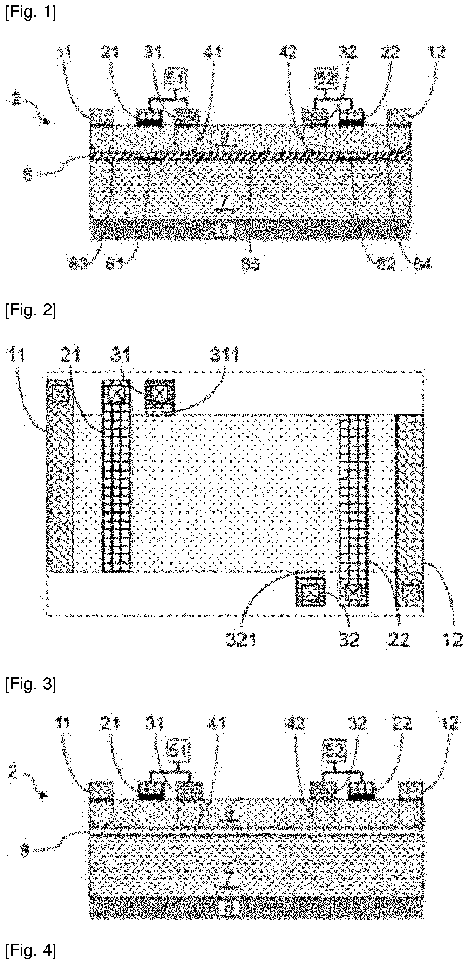

La figure 1 est une figure schématique d'un exemple de transistor 2 de type HEMT, c'est-à-dire un transistor à effet de champ à haute mobilité d'électrons, selon un mode de réalisation de l'invention. La figure 2 est une vue de dessus de ce transistor 2. Le transistor 2 comporte un substrat de silicium 6, présentant typiquement un léger dopage de type P. Une couche en matériau semi-conducteur 7 en alliage binaire d'un nitrure d'un élément de type III (en l'occurrence du GaN) est ménagée au-dessus du substrat 6. Une couche en matériau semi-conducteur dite barrière, d'alliage ternaire d'un nitrure d'un élément de type III (en l'occurrence du AlGaN) 9 est ménagée au-dessus de la couche 7. Une couche de gaz d'électrons 8 est intrinsèquement formée à l'interface entre la couche 7 et la couche 9.

Le transistor 2 comporte une première électrode de conduction 11 et une deuxième électrode de conduction 12, entre lesquelles un courant doit sélectivement être établi ou interrompu.

Le transistor 2 comporte en outre une première grille de commande 21, et une deuxième grille de commande 22. Les grilles de commande 21 et 22 sont disposées entre les électrodes de conduction 11 et 12, afin que chacune des grilles 21 et 22 puisse interrompre le courant entre les électrodes de conduction 11 et 12. Les grilles de commande 21 et 22 surplombent ainsi la couche de gaz d'électrons 8 de part en part selon une direction transversale, c'est-à-dire une direction perpendiculaire à la direction de conduction entre les électrodes de conduction 11 et 12.

Le transistor 2 comporte également une première électrode de référence 31 et une deuxième électrode de référence 32. Les électrodes de référence 31 et 32 sont connectées électriquement à la couche de gaz d'électrons 8, à proximité des électrodes de commande respectives 21 et 22. Les électrodes de référence 31 et 32 sont connectées électriquement à la couche de gaz d'électrons par l'intermédiaire de liaisons électriques respectives 311 et 321. Les électrodes de référence 31 et 32 sont ici disposées entre les électrodes de commande 21 et 22. En particulier, les électrodes de référence 31 et 32 sont disposées à proximité respectivement des grilles 21 et 22.

Les électrodes 11, 12, 31 et 32 et les grilles 21 et 22 sont ici ménagées au-dessus de la couche 9.

La couche 8 comporte une zone de canal 81, à la verticale de la grille 21. La zone de canal 81 est rendue sélectivement conductrice ou isolante en fonction de la tension appliquée sur la grille 21. La couche 8 comporte une zone de canal 82, à la verticale de la grille 22. La zone de canal 82 est rendue sélectivement conductrice ou isolante en fonction de la tension appliquée sur la grille 22. En fonction de la conception du transistor 2, la zone 81 rend la partie gauche de ce transistor 2 bloquée ou passante pour une différence de potentiel nulle entre l'électrode de référence 31 et la grille 21. Le transistor 2 est ici de type normalement passant. En fonction de la conception du transistor 2, la zone 82 rend la partie droite de ce transistor 2 bloquée ou passante pour une différence de potentiel nulle entre l'électrode de référence 32 et la grille 22. Le transistor 2 est ici de type normalement ouvert.

La couche 8 comporte également une zone 83, s'étendant entre l'électrode 11 et la zone 81. La zone 83 forme une liaison électrique entre l'électrode 11 et la zone de canal 81. L'électrode 11 est connectée électriquement de façon connue en soi à la zone 83, par exemple par un dopage localisé de la couche 9 sous l'électrode 11. La couche 8 comporte également une zone 84, s'étendant entre l'électrode 12 et la zone 82. La zone 84 forme une liaison électrique entre l'électrode 12 et la zone de canal 82. L'électrode 12 est connectée électriquement de façon connue en soi à la zone 84, par exemple par un dopage localisé de la couche 9 sous l'électrode 12. La distance entre les zones 83 et 84 est avantageusement au moins égale à 3µm, de préférence au moins égale à 6µm, enfin de préférence au moins égale à 10µm, en vue de garantir une tension de claquage élevée pour le transistor 2. La couche 8 comporte également une zone 85 centrale, située entre les zones 81 et 82. La zone de conduction 85 est séparée des zones de conduction 83 et 84 par l'intermédiaire des zones de canal 81 et 82 respectivement. La liaison électrique 311 est connectée à la zone de conduction 85 à proximité de la zone de canal 81. La liaison électrique 311 permet ainsi d'appliquer, sur l'électrode de référence 31, le potentiel de la zone de conduction 85 au plus proche de la zone de canal 81. La liaison électrique 311 est ici formée d'un prolongement ou saillie latérale de la couche de gaz d'électrons 8 (en particulier de la zone 85), jusqu'à la verticale de l'électrode de référence 31. La liaison électrique 321 est connectée à la zone de conduction 85 à proximité de la zone de canal 81. La liaison électrique 321 permet ainsi d'appliquer, sur l'électrode de référence 32, le potentiel de la zone de conduction 85 au plus proche de la zone de canal 82. La liaison électrique 321 est ici formée d'un prolongement ou saillie latéral de la couche de gaz d'électrons 8 (en particulier de la zone 85), jusqu'à la verticale de l'électrode de référence 32.

Afin de favoriser la compacité du transistor 2, la zone 85 est avantageusement disposée entre un groupe de contacts de la grille 21 et de l'électrode 11, et un groupe de contacts de la grille 22 et de l'électrode 12. Ces groupes de contacts sont ainsi disposés de part et d'autre de la zone 85 selon la direction transversale. Avantageusement, la zone 85 est avantageusement disposée entre un groupe de contacts de la grille 21, de l'électrode 31 et de l'électrode 11, et un groupe de contacts de la grille 22, de l'électrode 31 et de l'électrode 12.

La couche 9 comporte une zone 41, à la verticale de l'électrode 31. La zone 41 connecte l'électrode 31 à la liaison électrique 311, par exemple par un dopage localisé de la couche 9 à la verticale de l'électrode 31. La distance entre la liaison 311 et la zone 81 (soit la distance entre les points les plus proches de la liaison 311 et de la zone 81) est avantageusement au plus égale à 1,5 fois la longueur de la grille 21. La distance entre la liaison 311 et la zone 81 est avantageusement au plus égale à 0,15 fois la largeur de la zone 85. La distance entre la liaison 311 et la zone 81 est avantageusement de préférence au plus égale à 2µm. La couche 9 comporte également une zone 42, à la verticale de l'électrode 32. La zone 42 connecte l'électrode 32 à la liaison électrique 321, par exemple par un dopage localisé de la couche 9 à la verticale de l'électrode 32. La distance entre la liaison 321 et la zone 82 (soit la distance entre les points les plus proches de la liaison 321 et la de zone 82) est avantageusement au plus égale à 1,5 fois la longueur de la grille 22. La distance entre la liaison 321 et la zone 82 est avantageusement au plus égale à 0,15 fois la largeur de la zone 85. La distance entre la liaison 321 et la zone 82 est avantageusement de préférence au plus égale à 2µm. Ces paramètres favorisent la récupération d'un potentiel de référence à proximité du canal dont on souhaite contrôler l'état de conduction.

Un circuit de commande 51 est configuré pour appliquer une tension de polarisation sur la grille 21 définie par rapport à la tension de l'électrode de référence 31. Une telle commande par rapport au potentiel d'une électrode de référence permet d'éviter de devoir référencer le potentiel d'une grille par rapport au potentiel de son électrode de conduction, ce qui s'avère avantageux pour un transistor bidirectionnel pour laquelle un circuit de pilotage des grilles est aisé à dimensionner puisque la différence de potentiel est réduite entre les électrodes de référence 31 et 32. De façon similaire, un circuit de commande 52 est configuré pour appliquer une tension de polarisation sur la grille 22 définie par rapport à la tension de l'électrode de référence 32. Le transistor 2 est ici isolé d'autres composants électroniques par l'intermédiaire de tranchées d'isolation non illustrées.

Un tel transistor 2 se comporte comme un commutateur bidirectionnel pilotable, pour chaque direction, par une tension appliquée entre une grille et une référence de potentiel, mais dont l'encombrement et la résistance à l'état passant sont comparables à un transistor unidirectionnel. En effet, à l'état bloqué du transistor 2, la tension de claquage est ici assurée par toute la distance entre les grilles 21 et 22 (correspondant à la zone 85). Par ailleurs, cette tension de claquage est obtenue sans dégrader la résistance à l'état passant du transistor 2, puisque la distance de conduction dans le gaz d'électrons 8 est sensiblement égale à la distance participant à la tension de claquage du transistor 2 à l'état bloqué, contrairement à l'enseignement du document EP2736078.

Les notations suivantes vont être utilisées : V11 : tension sur l'électrode 11 ; V12 : tension sur l'électrode 12 ; V51 : la différence de potentiel appliquée entre la grille 21 et l'électrode de référence 31 ; V52 : la différence de potentiel appliquée entre la grille 21 et l'électrode de référence 32 ; V1211 la différence de potentiel entre les électrodes de conduction 11 et 12.

Dans le présent exemple, le transistor 2 est de type normalement ouvert, avec une tension de seuil Vth positive.

Lorsque les tensions V51 et V52 sont égales entre elles et supérieures à Vth, le courant circule dans la couche 8 entre les électrodes 11 et 12, de l'électrode 11 à l'électrode 12. Le transistor est alors dans un premier mode de fonctionnement : état passant symétrique. Ce comportement est illustré par la figure 3 et le diagramme tension / courant de la figure 4. La couche de gaz d'électrons 8 s'étend ici en continu jusqu'au contact électrique avec les électrodes de conduction 11 et 12. Le transistor 2 présente ainsi un comportement similaire avec un sens du courant opposé, lorsque V11 est supérieure à V12 ou lorsque V12 est supérieure à V11. Dans ce mode de fonctionnement, le transistor 2 est utilisé en modulation de courant par l'amplitude des différences de potentiel V51 et V52. La mesure a ici été effectuée avec une tension V1211 de -3V à 3V, et des différences de potentiel V51 et V52 de 6V (avec Vth=2V).

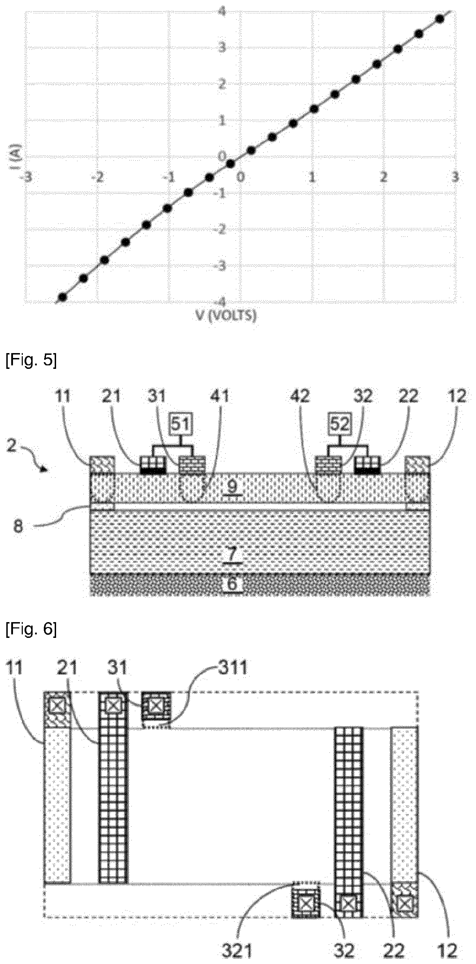

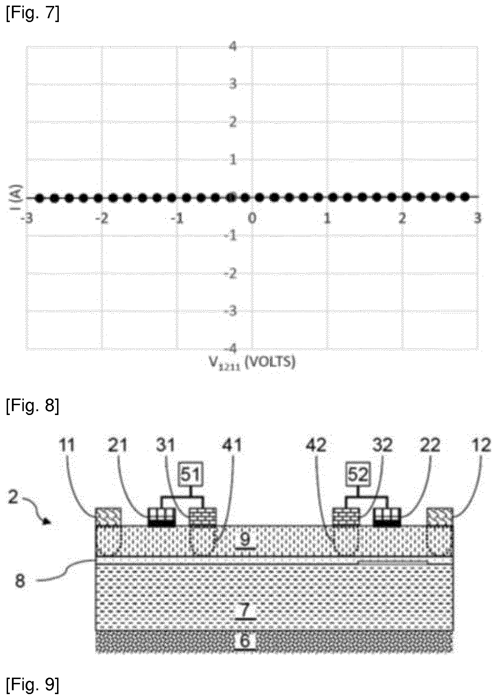

Lorsque, en revanche, V51 et V52 sont inférieures à Vth, quelles que soient les tensions V11 et V12, le transistor 2 est bloqué dans les 2 sens. Il s'agit d'un deuxième mode de fonctionnement : état bloqué symétrique. Ce comportement est illustré par les figures 5, 6 et le diagramme tension / courant de la figure 7. La couche de gaz d'électrons 8 est ici supprimée entre les contacts avec les électrodes 11 et 12. Dans cet exemple, les différences de potentiel V51 et V52 sont égales à -6V.

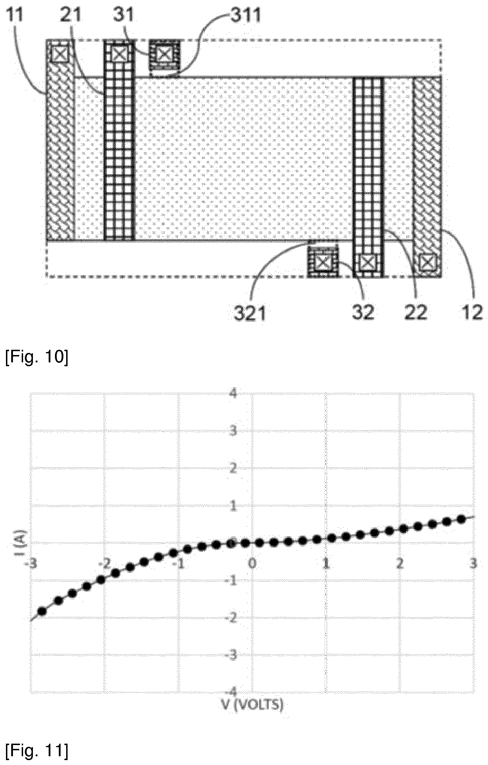

Lorsque V51 > V52 > Vth (et réciproquement si V52 > V51 > Vth), le transistor 2 présente un courant régulé par les tensions de grille, en particulier V52 qui est la plus faible : la grille 51 laisse passer plus d'électrons que la grille 52 dans la couche de gaz d'électrons 802. Il s'agit d'un troisième mode de fonctionnement : l'état passant dissymétrique. Le transistor 2 se comporte en diode pour une conduction de l'électrode 12 vers l'électrode 11. Le courant est relativement faible de l'électrode 11 vers l'électrode 12. Ce comportement est illustré par les figures 8, 9 et le diagramme tension / courant de la figure 10. Dans cet exemple Vth=2V et les différences de potentiel V51 et V52 sont respectivement de 6V et de 3V.

Lorsque V51 > Vth > V52, on obtient un fonctionnement dissymétrique à l'état bloqué : le transistor 2 se comporte encore comme une diode pour une conduction de l'électrode 12 vers l'électrode 11. Le courant est bloqué de l'électrode 11 vers l'électrode 12, comme illustré à la figure 11. Dans cet exemple, Vth=2V et les différences de potentiel V51 et V52 sont respectivement de 6V et de 1V.

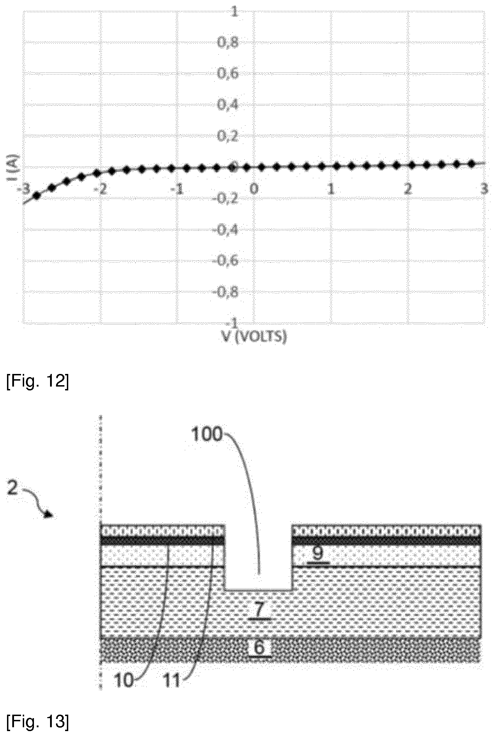

Les figures 12 à 16 sont des vues en coupe d'un transistor HEMT 2 à différentes étapes d'un exemple de procédé de fabrication. Les figures 12 à 16 illustrent la partie droite du transistor 2, au niveau de l'électrode de conduction 12, de la grille 22 et de l'électrode de référence 32. La partie gauche du transistor 2 inclut un symétrique de cette partie droite, avec laquelle elle est reliée par une partie intermédiaire incluant la zone de conduction 85.

Pour le transistor 2 en cours de formation illustré à la figure 12, on dispose ici d'un substrat de silicium 6 présentant typiquement un léger dopage de type P, d'épaisseur 1mm, sur lequel une couche semi-conductrice 7 en alliage binaire d'un nitrure d'un élément de type III (par exemple du GaN) est ménagée. Une couche semi-conductrice barrière 9, d'alliage ternaire d'un nitrure d'un élément de type III (par exemple du AlGaN, par exemple avec 20 à 25% d'Aluminium, pour une couche 7 en GaN), par exemple d'épaisseur 24nm, est ménagée au-dessus de la couche 7. Une couche de gaz d'électrons (non représentée ici) est intrinsèquement formée à l'interface entre la couche 7 et la couche 9. La couche de gaz d'électrons peut être délimitée selon la configuration illustrée en vue de dessus à la figure 12. Une couche de passivation 10 est formée sur la couche 9. La couche 10 peut par exemple être réalisée in situ, juste après le dépôt de la couche 9. La couche 10 peut par exemple être en Si₃N₄ et présenter une épaisseur de 10nm. La couche 10 est recouverte d'une couche d'isolant 11, formée par exemple de Si₃N₄. Une gorge 100 est notamment ménagée au niveau de la grille à former, par gravure anisotrope des couches 11, 10 et 9. La gorge 100 s'étend ici en partie dans la couche 7. Par exemple, la gorge 100 présente une largeur comprise entre 0,25 et 0,5µm, et une profondeur comprise entre 225 et 325nm. La gorge 100 s'étend de part en part de la couche de gaz d'électrons, séparant celle-ci en deux domaines disjoints.

Comme illustré à la figure 13, on réalise ensuite le contact de la grille 22 par dépôts successifs des couches suivantes. La couche 220, constituée d'un matériau type Al₂O₃/SiO₂, est tout d'abord déposée, par exemple selon un procédé de dépôt de couche atomique (acronyme ALD pour Atomic Layer Deposition en langue anglaise) pleine plaque, puis subit éventuellement un recuit post dépôt. La couche 221, incluant par exemple un matériau de type TiN, est déposée ensuite, par exemple selon un procédé de dépôt physique en phase vapeur (acronyme PVD pour Physical Vapor Deposition en langue anglaise) pleine plaque. La couche 222, incluant un matériau type W ou AlCu, est déposée enfin, par exemple selon un procédé dépôt chimique en phase vapeur (acronyme CVD pour Chemical Layer Deposition en langue anglaise) pleine plaque. Par gravure, on ne conserve ensuite de l'ensemble des couches 220, 221 et 222 que l'empilement de grille, présentant typiquement une zone dépassant par exemple de 25µm au moins de part et d'autre de la gorge 100 décrite à la figure 12. La couche d'isolant 11 est ainsi accessible sur le reste du composant.

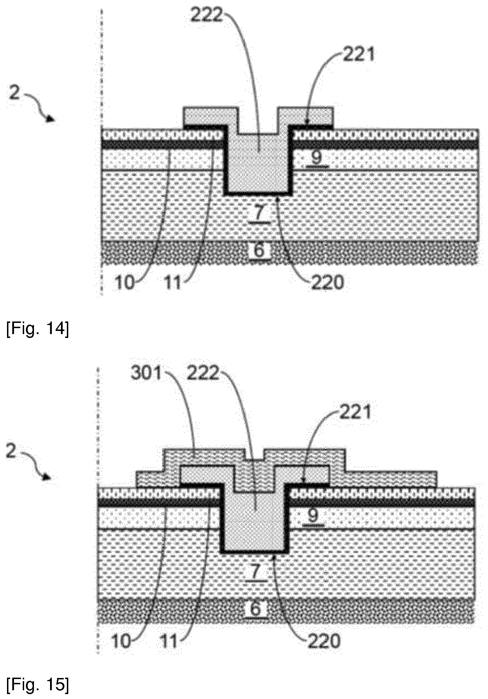

Comme illustré à la figure 14, on réalise ensuite la couche 301 par dépôt pleine plaque sur une épaisseur comprise par exemple entre 100 et 200nm d'un matériau, typiquement du SiO₂. De part et d'autre de l'empilement des couches 220, 221 et 222, on réalise ensuite une gravure de la couche 301 pour libérer l'accès à la couche d'isolant 11 sur une longueur par exemple 1 à 1,5µm.

En figure 15, on illustre l'ouverture, par procédé de lithographie, d'un accès 400 pour le contact de référence, d'un accès 401 pour le contact de grille, et d'un accès 402 pour le contact de l'électrode de conduction.

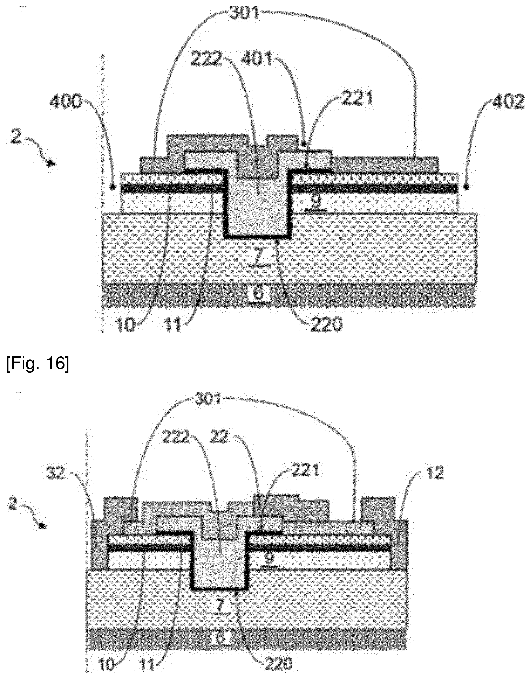

A la figure 16, on illustre le dépôt du métal du contact de l'électrode de référence 32, du métal du contact de grille 22, et du métal du contact de l'électrode de conduction 12. Ces dépôts seront avantageusement réalisés en alliage TiAlCu, déposé pleine plaque avant de subir un procédé de gravure par lithographie permettant de mettre en forme des contacts indépendants les uns des autres. On note que le contact de référence 32, situé vers la partie médiane du composant, et le contact d'électrode de conduction 12, situé à l'extrémité du composant, reposent sur la couche 7, tandis que le contact de grille 22 repose sur la couche 222.

Dans les exemples qui précèdent, on a décrit des électrodes de référence connectées électriquement à la zone 85 de la couche de gaz d'électrons par l'intermédiaire d'une extension latérale de cette couche de gaz d'électrons. On peut également envisager de réaliser la connexion électrique des électrodes de référence par un dépôt de métal s'étendant de la verticale de la zone 85 de la couche de gaz d'électrons jusqu'au niveau d'une zone latérale déportée, au niveau de laquelle une électrode de référence respective est connectée.

## Revendications

1. Dispositif incluant un transistor bidirectionnel à hétérojonction à effet de champ (2), **caractérisé en ce que** le transistor bidirectionnel comprend :
- des première et deuxième électrodes de conduction (11, 12), des première et deuxième grilles (21, 22) disposées entre les première et deuxième électrodes de conduction, et des première et deuxième électrodes de référence (31, 32) disposées entre les première et deuxième grilles ;
- une superposition d'une première couche semiconductrice (7) et d'une deuxième couche semiconductrice (9) de façon à former une couche de gaz d'électrons (8), la couche de gaz d'électrons comprenant :
- une première zone de canal (81) disposée à la verticale de la première grille ;
- une deuxième zone de canal (82) disposée à la verticale de la deuxième grille ;
- une première zone de conduction (83) s'étendant entre la première électrode de conduction et la première zone de canal ;
- une deuxième zone de conduction (84) s'étendant entre la deuxième électrode de conduction et la deuxième zone de canal ;
- une troisième zone de conduction (85) séparée des première et deuxième zones de conduction par l'intermédiaire les première et deuxième zones de canal respectivement ;
- une première liaison électrique (311) connectée à la troisième zone de conduction (85) à proximité de la première zone de canal et connectée à la première électrode de référence ;
- une deuxième liaison électrique (321) connectée à la troisième zone de conduction (85) à proximité de la deuxième zone de canal (82) et connectée à la deuxième électrode de référence ;
- le dispositif comprenant également un premier circuit de commande (51) connecté à la première électrode de référence (31), le premier circuit de commande étant programmé pour générer une tension de commande du transistor à partir de la tension de la première électrode de référence et programmé pour appliquer ladite tension de commande sur la première grille ;
- le dispositif comprenant également un deuxième circuit de commande (52) connecté à la deuxième électrode de référence (32), le deuxième circuit de commande étant programmé pour générer une tension de commande du transistor à partir de la tension de la deuxième électrode de référence et programmé pour appliquer ladite tension de commande sur la deuxième grille ;
- dans lequel lesdites première et deuxième grilles surplombent la couche de gaz d'électrons de part en part selon une première direction perpendiculaire à une direction de conduction entre les première et deuxième électrodes de conduction (11, 12), le transistor comportant des contacts respectifs pour la première grille, pour la deuxième grille, pour la première électrode de conduction et pour la deuxième électrode de conduction, la troisième zone de conduction étant disposée entre les contacts de la première grille et de la première électrode de conduction d'une part et des contacts de la deuxième grille et de la deuxième électrode de conduction d'autre part ;
- dans lequel lesdites première et deuxième liaisons sont des bandes de gaz d'électrons s'étendant en saillie par rapport à la troisième zone de conduction selon ladite première direction.

2. Dispositif (2) selon la revendication 1, dans lequel la distance entre les première et deuxième zones de conduction (83, 84) est au moins égale à 3µm.

3. Dispositif (2) selon la revendication 2, dans lequel la distance entre les première et deuxième zones de conduction (83, 84) est au moins égale à 6µm.

4. Dispositif (2) selon l'une quelconque des revendications précédentes, dans lequel la distance entre ladite première liaison (311) et ladite première zone de canal (81) est au plus égale à 1,5*Lg avec Lg la longueur de grille.

5. Dispositif (2) selon l'une quelconque des revendications précédentes, dans lequel la distance entre ladite première liaison (311) et ladite première zone de canal est au plus égale à 0,15*D, avec D la distance entre les première et deuxième zones de canal.

6. Dispositif (2) selon l'une quelconque des revendications précédentes, dans lequel la distance entre ladite première liaison (311) et ladite première zone de canal (81) est au plus égale à 2µm.

7. Dispositif (2) selon l'une quelconque des revendications précédentes, dans lequel la distance entre lesdites première et deuxième zones de conduction (83, 84) est au moins égale à 10µm.

8. Dispositif (2) selon l'une quelconque des revendications précédentes, dans lequel les premier et deuxième circuits de commande sont configurés pour appliquer simultanément des tensions de commande sur les première et deuxième grilles, selon des combinaisons sélectionnées dans le groupe constitué de :
- une tension de commande sur la première grille supérieure à la tension de seuil de cette grille et une tension de commande sur la deuxième grille supérieure à la tension de seuil de cette grille ;
- une tension de commande sur la première grille inférieure à la tension de seuil de cette grille et une tension de commande sur la deuxième grille supérieure à la tension de seuil de cette grille ;
- une tension de commande sur la première grille inférieure à la tension de seuil de cette grille et une tension de commande sur la deuxième grille inférieure à la tension de seuil de cette grille.

9. Dispositif (2) selon la revendication 8, dans lequel lesdits premier et deuxième circuits de commande sont configurés pour appliquer simultanément des tensions de commande sur les première et deuxième grilles avec une tension de commande sur la première grille supérieure à la tension de seuil de la première grille et une tension de commande sur la deuxième grille supérieure à la tension de seuil de la deuxième grille, la différence entre la tension de commande de la première grille et la tension de seuil de la première grille étant supérieure à la différence entre la tension de commande de la deuxième grille et la tension de seuil de la deuxième grille.

10. Dispositif (2) selon l'une quelconque des revendications précédentes, dans lequel les première et deuxième électrodes de référence comportent des contacts respectifs avec lesdites première et deuxième liaisons, la troisième zone de conduction étant disposée entre les contacts des première et deuxième électrodes de référence.

11. Dispositif (2) selon l'une quelconque des revendications précédentes, dans lequel lesdits premier et deuxième circuits de commande sont configurés pour appliquer des tensions de commande d'amplitudes différentes sur les première et deuxième grilles respectivement.

12. Dispositif (2) selon l'une quelconque des revendications précédentes, dans lequel les première et deuxième couches semiconductrices sont des alliages de GaN.
